Europäisches Patentamt

(19) European Patent Office

Office européen des brevets

(11) Publication number: **0 002 883**
**B1**

# EUROPEAN PATENT SPECIFICATION

(45) Date of publication of patent specification:
07.01.81

(51) Int. Cl.³: **H 01 L 23/36**

(21) Application number: **78300576.2**

(22) Date of filing: **01.11.78**

(54) A thermal interface between surfaces of a heat source and heat sink.

(30) Priority: **23.12.77 US 863640**

(43) Date of publication of application:
**11.07.79 Bulletin 79/14**

(45) Publication of the grant of the patent:
**07.01.81 Bulletin 81/1**

(84) Designated Contracting States:
**DE FR GB**

(56) References cited:
**FR-A-1 272 820**
**IBM TECHNICAL DISCLOSURE BULLETIN**
**vol. 2, April 1960,**
**New York**
**W. E. DUNKEL, "Diode heat sink",**
**page 69.**
**IBM JOURNAL OF RESEARCH AND DEVELOPMENT,**
**vol. 16, May 1972,**
**New York**
**J. B. RANDOLPH et al. "Design and Fabrication of heat transfer surfaces from superplastic material"**
**pages 283–291.**
**IBM TECHNICAL DISCLOSURE BULLETIN,**
**vol. 20, November 1977,**
**New York,**
**E. L. DOMBROSKI et. al., "Thermal Conduction Module", pages 2214–2215.**

(73) Proprietor: **International Business Machines Corporation, Armonk, N.Y. 10504 (US)**

(72) Inventor: **Dombroski, Edward L., 16 Catskill Avenue, Poughkeepsie New York 12603 (US)**
Inventor: **Pascuzzo, Albert L., 85 South Gate Drive, Poughkeepsie New York 12601 (US)**

(74) Representative: **Lewis, Alan J., IBM United Kingdom Patent Operations Hursley Park, Winchester, Hants, S021 2JN (GB)**

A Thermal Interface Between Surfaces of a Heat Source and Heat Sink

The invention relates to thermal systems in which heat is transferred through a thermal interface between a heat source and a heat sink.

Where a thermal interface is to be formed by connecting two surfaces together, it is desirable that the surfaces be finished very smoothly to avoid cavities due to surface roughness and that the surfaces be similarly shaped so that they mate relatively well to avoid air spaces therebetween. In the situation where flat surfaces are involved, the machining tolerances are such that the surfaces cannot be made exactly flat, and consequently when they are brought into contact do not touch at all places. Air, being a good insulator, provides a high thermal resistance interface in the places where the surfaces do not touch. To overcome this high resistance, thermal greases or other good heat conductive materials such as liquids and gases have been used. The thermal greases work relatively well, but they have the disadvantage of seeping out of the interface and of being generally messy.

U.S. specification No. 3 482 198 discloses a photosensitive device in which a heat conducting path is provided between a ceramic substrate and the base of the device by a shim of thin foil material. The illustrated shim comprises a sheet of material having an array of dimples or parts-pherical protuberances formed at regularly spaced positions over its surface, although it is stated that the protuberances may be formed by corrugating or cross-corrugating the sheet or merely by randomly crinkling the sheet. In any case whether the protuberances comprise dimples or are formed by corrugating or crinkling the sheet, the crests of the dimples, corrugations or crinkles will be either points or lines and will initially make point or line contact with the substrate. Even if the sheet is subject to deformation during assembly of the device, and no means for causing such deformation is disclosed in the US specification, only extended point contact or broadened line contact will be made.

The Applicant's invention is concerned with the transfer of heat between two surfaces through an intermediate sheet of good conducting material and ensures that there are substantial areas of thermal contact between the sheet and both the heat donating and the heat receiving surfaces. This is achieved by embossing the sheet to form a regular matrix of flat topped raised embossments spaced by columns and rows of flat bottomed grooves and by compressing the sheet. The extended flat top and bottom walls of the grooves ensure substantial area contact, as distinct from point or line contact. This substantial area contact, in turn, ensures a minimum thermal resistance at the interface.

In the IBM Technical Disclosure Bulletin, Vol. 20, No. 6, dated November 1977 at pages 2214/5 there is disclosed a thermal conduction module comprising an extended substrate carrying a dependant array of chips on its lower surface. Heat is conducted away from the chips by a multi-layer stack of preformed sheets of aluminium providing an array of upstanding lands or protuberances at locations corresponding to the locations of the chips. The area of each land is substantially equal to the area of the aligned chip with which the land makes face-to-face contact. The degree of contact depends on the flatness, and thus the area of contact, of the contacting surfaces. If either or both the contacting surfaces are rough, i.e. not exactly flat, voids or air spaces will occur between the surfaces introducing substantial thermal resistances.

As aforesaid, the applicants invention is concerned with this specific problem of obtaining a minimal thermal resistance between two substantially flat contacting surfaces. Thus, the TDB article does not provide a solution to the Applicants problem.

The IBM Journal of Research and Development, Volume 16, No. 3 dated May 1972, contains, between pages 283/291, an article concerned with the design and fabrication of heat transfer surfaces from superplastic material. The disclosed surface is formed from superplastic material and comprises a corrugated sheet, the corrugations running parallel to one another and being of zig-zag shape along their lengths. The corrugations have a U-section and heat is removed by air or water flow over the surface. The corrugations are designed to take advantage of turbulent fluid flow without the disadvantages of such flow, i.e. friction heat generation. The article is in no way concerned with the applicants problem of heat transfer through an interface between two adjacent substantially smooth surfaces and provides no solution thereto.

Accordingly the Applicant's invention provides a thermal conductor device in which heat is transferred through an interface between an extended substantially smooth heat emitting surface of a heat source and a parallel substantially smooth heat receiving surface of a heat sink, characterised in that the interface is provided by a sheet of good heat conducting material embossed to form a regular matrix of flat topped raised embossments spaced by columns and rows of flat bottomed grooves compressed between the surfaces.

An embodiment of the invention will now be described by way of example with reference to the accompanying drawings, in which:

Figure 1 is a cross-sectional view through the embodiment,

Figure 2 is a view on the line II–II of Figure 1,

Figure 3 is a view on the line III–III of Figure 2,

Figure 4 is a diagrammatic perspective view showing one way in which a sheet member can be embossed.

In this example, the embodiment comprises a so-called "gas encapsulated module" somewhat similar to that disclosed in U.S. specification No. 3 993 123 but modified to embody the invention claimed herein.

The module comprises an array of semi-conductor chips 16 mounted on a pinned board 17. A heat-conducting stud or cylinder 18 registered with each chip 16 and is urged into Close thermal contact therewith by an associated spring 19. The studs and springs are received in blind-bores 21 in a module housing 10. The space around the studs 18 is filled with an inert, good thermally conducting gas or vapour which in this example is helium. A thermal interface 20 fits between a heat sink cold plate 12 and the housing 10. The interface 20 is formed from an embossed thin sheet or foil 14 of good heat conducting material, such as aluminium or copper which is compressed between the plate 12 and the housing 10. The cold plate 12 is secured to the housing by clips or fittings 22.

The module housing 10 serves as a heat conducting path for the heat generated in use by the chips 16. The heat passes from the chips 16 to the associated studs 18 and from the studs 18 through the gas to the housing 10. The heat is then conducted across the interface 20 to the cold plate 12.

The surfaces forming the interface 20 have been carefully machined or formed and finished to a substantially smooth texture. Once these surfaces have been machined and finished they should substantially mate over their abutting areas. However, even though the surfaces have been machined flat and finished smooth, they cannot be made exactly flat and smooth because of the machining tolerances involved and the inability to remove all surface imperfections. Thus, there are air spaces or voids between the mating surfaces. Since air is an insulator, the thermal resistance of the interface formed by direct contact between the machined and smoothed surfaces would be relatively high because of the air voids there-between. When the surfaces have been machined and smoothed, the embossed aluminium or copper thermal conductor 14 is located therebetween. The cold plate 12 and the module housing 10 top surface with the embossed material 14 located therebetween are clamped together by clamps 22 to give an even pressure of the mating surfaces towards one another. This mating pressure causes the embossed material 14 to deform as a function of the air voids or spaces between the mating surfaces thereby decreasing the thermal resistance of the thermal interface 20. Over areas of the mating survaces which would actually contact one another (i.e. between the air voids), the corresponding areas of the embossed foil 14 will be completely compressed and in those areas where there would be voids, that is, the surfaces do not make contact, the embossed foil will be non-compressed or compressed as a function of the height of the void.

We have found that surface machining can be performed accurately to within 2.5 to 5 × $10^{-3}$ cms. Even with these small voids, it has been found that 2.5 × $10^{-3}$ cms thick aluminium fold embossed to a height between 2.5 and 3.7 × $10^{-2}$ cms and with an embossment width of between 2.5 and 5 × $10^{-2}$ cms reduces the thermal resistance 30% to 100% of the original resistance having no interface material.

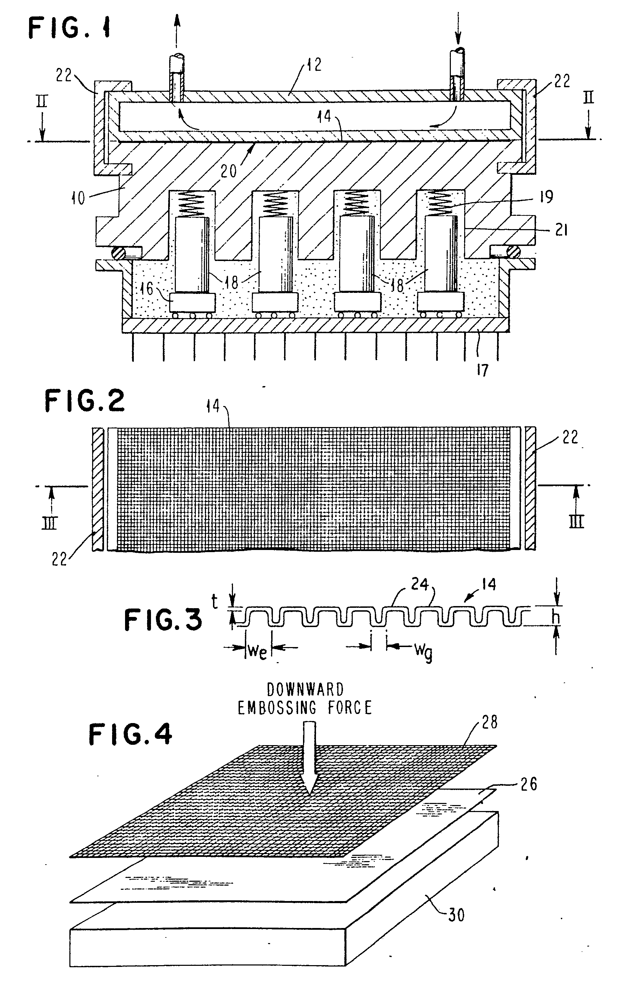

A plan view of the embossed foil 14 used between the module 10 and the cold plate 12 of Figure 1 is shown in Figure 2. Figure 2 is taken on the line II-II of Figure 1 showing the foild 14 before deformation thereof caused by clamping the cold plate 12 to the housing 10. Figure 3 shows an enlarged, fragmentary cross-sectional view taken along the lines III-III of Figure 2. This shows the relative thickness (t) of the material, the height (h), the width ($w_e$) of the embossments and the width (wg) of the grooves. In this example $\underline{t}$ is 2.5 × $10^{-3}$ cms, $\underline{h}$ is between 2.5 and 3.7 × $10^{-2}$ cms, $w_e$ is between 2.5 and 5 × $10^{-2}$ cms and $w_g$ is between 2.0 × $10^{-2}$ cms and 2.3 × $10^{-2}$ cms. The bosses or protuberances 24 (Figure 3) consist of substantially uniform small squares which tend to flatten out when subjected to a flattening pressure. Although the embossed foil is shown as being flat in Figures 2 and 3, it is flexible and, therefore easily adaptable to other geometric shapes.

During the lifetime of the cooling module shown in Figure 1, it may be necessary to service the module and thus remove the cold plate. The embossed thin heat conductive material is sufficiently cheap that a new piece of material can be inserted when reassembling the module. This provides a distinct advantage over the thermal greases utilized heretofore.

It is relatively simple to emboss thin sheets of heat conductive material to obtain the advantages when used in a thermal interface. A sheet of commercial aluminium foil 26 approximately 2.5 × $10^{-3}$ cms thick was inserted between a wire screen 28 having approximately 6–7 grids per cm, each grid cross-over point being 3.3 × $10^{-2}$ cms thick using 1.5 or 1.8 × $10^{-2}$ cms wire, and a resilient material block 30 such as rubber. The embossing is obtained by applying a suitable downward pressure, indicated by the arrow in Figure 4, on the screen which presses against the foil backed by the rubber pad or block. The wire of the screen presses into the foil backed by the resilient material resulting in a boss or protuberance 24 in the foil at each grid square of the screen. Thus, each groove between the protuberances 24 will have a width measurement equal to the thickness of the wire plus twiche the thickness of the foil i.e. 2.0 × $10^{-2}$ cms to 2.3 × $10^{-2}$ cms.

The material cost for an embossed foil is negligible and manufacture thereof (embossing) is a simple manufacturing process. It is easy to apply and results in excellent reduction in thermal resistance of the interface. It can be adapted to any geometrical shape and allows the manufacturing tolerances on the interfacing parts to be less stringent. Since the initial foil material and the manufacture thereof is relatively cheap, the embossed foil is expendible and can be easily replaced when disassembly and reassembly is required.

What is mechanically occurring, during the application of the pressure across the surfaces between which the embossed material is located, is that the embossing is flattening out at different rates and by different amounts throughout the surface area being joined. The rate and amount of deformation of the embossing is a function of the air voids or spaces. The arrangement reduces the interface resistance, thereby improving the thermal performance across the interface which in some cases is absolutely necessary in order to achieve a workable cooling scheme.

While the invention has been particularly shown and described with reference to a particular example thereof, it will be understood by those skilled in the art that the various changes in form and detail may be made therein.

Thus, the contacting surfaces need not be flat or plane. They may be of any matching or similar configuration. The thermal interface provided by the invention may be used in any apparatus or structure in which heat is to be transferred between two members by conduction between two mating surfaces.

## Claims

1. A thermal conductor device in which heat is transferred through an interface between an extended substantially smooth heat emitting surface of a heat source and a parallel substantially smooth heat receiving surface of a heat sink, characterised in that the interface is provided by a sheet of good heat conducting material embossed to form a regular matrix of flat topped raised embossments spaced by columns and rows of flat bottom grooves compressed between the surfaces.

2. A thermal conductor device as claimed in claim 1, further characterised in that the sheet has a thickness (t) of $2.5 \times 10^{-3}$ cms prior to embossing and after embossing has a height (h) between $2.5 \times 10^{-2}$ cms and $3.7 \times 10^{-2}$ cms.

3. A thermal system as claimed in claim 1 or 2, further characterised in that the top of each embossment is between $2.5 \times 10^{-2}$ cms wide ($w_e$) and the bottom of each groove is between $2.0 \times 10^{-2}$ and $2.3 \times 10^{-2}$ cms wide ($w_g$).

## Patentansprüche

1. Wärmeleitende Vorrichtung, durch die Wärme über eine Trennfläche zwischen einer ausgedehnten, im wesentlichen glatten wärmeabgebenden Oberfläche einer Wärmequelle und einer dazu parallelen im wesentlichen glatten wärmeaufnehmenden Oberfläche einer Wärmesenke übertragen wird, dadurch gekennzeichnet, dass die Trennfläche durch eine Folie eines gut wärmeleitenden Materials gebildet ist, welche durch Prägung eine regelmässige Matrix von erhabenen Prägungen mit ebener Oberfläche aufweist, die durch Spalten und Zeilen von zwischen diesen Oberflächen liegenden eingedrückten Vertiefungen mit flachem Boden getrennt sind.

2. Wärmeleitende Vorrichtung nach Anspruch 1, dadurch gekennzeichnet, dass die Folie vor dem Prägen eine Dicke (t) von $2.5 \times 10^{-3}$ cm und nach dem Prägen eine Höhe (h) zwischen $2.5 \times 10^{-2}$ cm und $3.7 \times 10^{-2}$ cm aufweist.

3. Wärmeleitendes System nach Anspruch 1 oder 2, dadurch gekennzeichnet, dass die Oberseite jeder Prägung zwischen $2.5 \times 10^{-2}$ und $5.0 \times 10^{-2}$ cm breit ($w_e$) und der Boden jeder Vertiefung zwischen $2.0 \times 10^{-2}$ und $2.3 \times 10^{-2}$ cm breit ($w_g$) ist.

## Revendications

1. Dispositif de conduction thermique dans lequel la chaleur est transférée au travers d'un élément intermédiaire disposé entre, d'une part une première surface d'une source de chaleur, cette surface étant étendue, pratiquement lisse et émettant de la chaleur et d'autre part, une seconde surface d'un dispositif de dissipation de chaleur, cette seconde surface étant parallèle à la première surface, pratiquement lisse et recevant la chaleur, caractérisé en ce que l'élément intermédiaire consiste en une feuille d'un matériau à bonne conduction thermique dont la forme, obtenue par formage, est celle d'une matrice régulière de bossages à partie supérieure plate séparés par des colonnes et des rangées de gorges à fond plat.

2. Dispositif selon la revendication 1 caractérisé en outre en ce que la feuille a une épaisseur (t) de $2.5 \times 10^{-3}$ cm avant formage et une hauteur (h) comprise entre $2.5 \times 10^{-2}$ et $3.7 \times 10^{-2}$ cm après formage.

3. Dispositif selon la revendication 1 ou 2 caractérisé en outre en ce que la partie supérieure de chaque bossage a une largeur ($w_e$) comprise entre $2.5 \times 10^{-2}$ et $5.0 \times 10^{-2}$ cm et en ce que le fond de chaque gorge a une largeur ($w_g$) comprise entre $2.0 \times 10^{-2}$ et $2.3 \times 10^{-2}$ cm.

**FIG. 1**

**FIG.2**

**FIG.3**

DOWNWARD
EMBOSSING FORCE

**FIG.4**